# EUROPEAN PATENT APPLICATION

(11) **EP 1 615 166 A1**
(43) Date of publication of application: **11.01.2006**
(21) Application number: 04291849.0
(22) Date of filing: 07.07.2004
(51) Int. Cl.: G06K 19/077, H01L 23/498, G06K 19/02

(54) **Carrier tape for chip modules and method of manufacturing a chip card**

(71) Applicant: Axalto S.A., 92120 Montrouge (FR)
(72) Inventor: Nerot, Dorothée c/o Axalto SA, 92120 Montrouge (FR); Reignoux, Yves c/o Axalto SA, 92120 Montrouge (FR); Groeninck, Denis c/o Axalto SA, 92120 Montrouge (FR)

(57) **Abstract**

The carrier tape comprises a dielectric layer (12) with a backside (14) and a front side (18), adapted to support a chip (16) at a chip location on the back side, and a conductive layer (20), arranged on the front side of the dielectric layer as a leadframe patterned with contact pads (22) to be connected to respective terminals of the chip. The carrier tape further comprises an additional, perforated layer (30), arranged on the backside (14) of the dielectric layer, said additional layer being perforated so as to define a peripheral wall surrounding a clearance area (32) around the chip location. The peripheral wall provided by the perforated layer thereby forms a containment barrier against the flow of a coating resin (28) dispensed over the chip in the clearance area.

## Description

### BACKGROUND OF THE INVENTION

### Field of the invention

The present invention generally relates to the manufacturing of chip cards, in particular the manufacturing of chip modules before embedding them into card bodies.

### Background art

More specifically, the chip modules are conventionally manufactured from a carrier band provided with chips mounted thereon in a row at regular intervals. The carrier band is comprises a flexible dielectric layer combined to a conductive layer forming a leadframe or metallic grid defining contact pads to which respective terminals of the chip are connected by techniques such as TAB (Tape Automated Bonding) or wire-bond. Once the connections between the contact pads and the chip are made, the whole chip and connection wires are coated in a protective resin which is then hardened or cross-linked.

After suitable electrical tests, the individual modules are pressed out from the carrier band to be further embedded in a card body, typically by gluing the module to the card by means of a liquid adhesive or by fusing a hot-melt adhesive.

One difficulty in this process is to precisely control the application of the protective resin during the coating step.

In particular, the resin, which is typically an epoxy resin, may be rather viscous so that the way it flows when applied onto the carrier band may be difficult to predict and control. It is therefore somewhat difficult to dispense the appropriate quantity of resin over the chip in order to obtain a complete coating not only of the chip but also of the very thin wires connecting the terminals of the chip to the contact pads of the leadframe, yet avoiding any overflow of excess resin outside the coating area.

One possibility which has been proposed to improve this point is to use a mask applied on the carrier band during the coating step in order to delimit the coating area. The coating step is accordingly divided in sub-steps including: (i) positioning the mask against the surface of the carrier band; (ii) dispensing the resin over the chip in the coating area; (iii) cross-linking the resin in an oven; and (iv) removing the mask. This of course makes the whole process more complex, with consequences on the overall manufacturing costs, throughput and additional process adjustments and controls which are needed.

Further, as explained above, when the individual module is embedded in the recess of the card body, an adhesive should be used to bond the module to the card body.

Such adhesive is typically a liquid adhesive (such as a cyanoacrylate glue) or a "hot-melt" adhesive. In this latter case, there should be provided in the process a specific step of applying a film of hot-melt adhesive component on the periphery of the modules before embedding. This is generally performed before the individual modules are pressed out from the carrier band, by applying an adhesive tape provided with cut-outs such that only the edge of the module be covered.

Accordingly, the choice of using a hot-melt adhesive material for bonding the module to the card body requires an additional step in the overall module manufacturing process, before the individual modules are pressed out from the finished carrier band.

### SUMMARY OF THE INVENTION

It is therefore an object of the invention to provide a carrier band for a chip card module, and a method of manufacturing a chip card, which mitigate these difficulties and make the process for manufacturing the module simpler and more reliable.

Specifically, a first object of the invention is to enable a precise application of the coating resin, irrespective of the small variations in the viscosity and quantity dispensed of such resin that are inherent to any industrial process, yet providing a constant and precise definition of the area that will be coated.

A further object of the invention is to attain such precise control of the coated area without adding any extra step to the manufacturing process, for instance without requiring additional steps of application and removal of a mask, as in the prior known technique described above.

Another object of the invention is to provide a simpler process when hot melt adhesive is chosen for embedding the module into the card body, in particular by avoiding any extra step for the application of a hot melt film on the periphery of the modules.

Generally, an object of the invention is to streamline a chip card manufacturing process, through reduction of the number of steps necessary for the coating and/or embedding of the modules, hence permitting faster and more cost-effective production of chip cards, yet keeping quality standards at least at the same level than before.

The carrier band of the invention is of the type including a dielectric layer with a backside and a front side, adapted to support a chip at a chip location on the back side, and a conductive layer, arranged on the front side of the dielectric layer as a leadframe patterned with contact pads to be connected to respective terminals of the chip.

According to the invention, the carrier band comprises an additional, perforated layer, arranged on the backside of the dielectric layer, said additional layer being perforated so as to define a peripheral wall surrounding a clearance area around the chip location, whereby said peripheral wall provided by the perforated layer forms a containment barrier against the flow of a coating resin dispensed over the chip in the clearance area.

In a first embodiment, the thickness of the perforated layer is chosen as a function of the volume and viscosity of the resin and of the size of the clearance area, so that the level of the resin once dispensed is higher than the level of the peripheral wall, yet the viscosity of the resin prevents the resin from overflowing the peripheral wall. Typically the corresponding thickness of the perforated layer is in the range 30-40 µm.

In a second embodiment, the thickness of the perforated layer is chosen as a function of the volume of the resin and of the size of the clearance area, so that the level of the resin once dispensed is lower than the level of the peripheral wall. Typically the corresponding thickness of the perforated layer is in the range 200-400 µm.

The structure of the carrier band of the invention enables a reduction of the thickness of the dielectric layer, which may be a thin layer with a thickness in the range 30-50 µm.

The perforated layer advantageously includes on its side contacting the dielectric layer an adhesive coating material for adhesion to said dielectric layer and/or, on its side opposing the dielectric layer, a surface coating with a hot-adhesive material. alternatively, the perforated layer may be as such made from a hot-adhesive material.

The perforated layer preferably comprises a plastic material of the group comprising PET, ABS, PVC, their mixtures and derivatives.

The invention also sets forth a method of manufacturing a chip card, including the steps of:
a) providing a carrier band comprising: (i) a dielectric layer with a front side and a back side, (ii) a conductive layer arranged on the front side of the dielectric layer as a leadframe patterned with contact pads, and (iii) an additional, perforated layer arranged on the backside of the dielectric layer, said additional layer being perforated so as to define a peripheral wall surrounding a clearance area;
b) placing a chip onto the back side of the carrier band at a chip location in the clearance area;
c) connecting the contact pads of the conductive layer to respective terminals of the chip;
d) dispensing a coating resin over the chip in the clearance area, the peripheral wall provided by the perforated layer forming a containment barrier against the flow of said resin;
e) hardening the resin;
f) cutting the individual module from the carrier band; and
g) embedding said module in a card body to provide a chip card.

In a first implementation of the method, the perforated layer includes on its side opposing the dielectric layer a surface coating with a hot-adhesive material, or is made from a hot-adhesive material, and embedding step g) includes heating the carrier band and adhering the module to the card body by melting the hot-adhesive coating of the peripheral wall.

In a second implementation of the method, embedding step g) includes applying a liquid adhesive on the upper surface of the peripheral wall of the perforated layer and adhering the module to the card body by pressing said upper surface against the card body.

### BRIEF DESCRIPTION OF THE DRAWINGS

The foregoing and other objects, aspects and advantages of the invention will be better understood from the following detailed description of a preferred embodiment of the invention with reference to the drawings, in which:
Figure 1 is a schematic view of the different parts making up a chip card module according to the prior art.
Figure 2 is a schematic view of the different parts making up a chip card module according to the invention.
Figure 3 is a view of the module after application of the resin, according to a first embodiment of the invention.
Figure 4 is a view of the module after application of the resin, according to a second embodiment of the invention.
Figure 5 illustrates the chip module and the recess in the card body, in the course of the embedding step.

### DETAILED DESCRIPTION OF A PREFERRED EMBODIMENT OF THE INVENTION

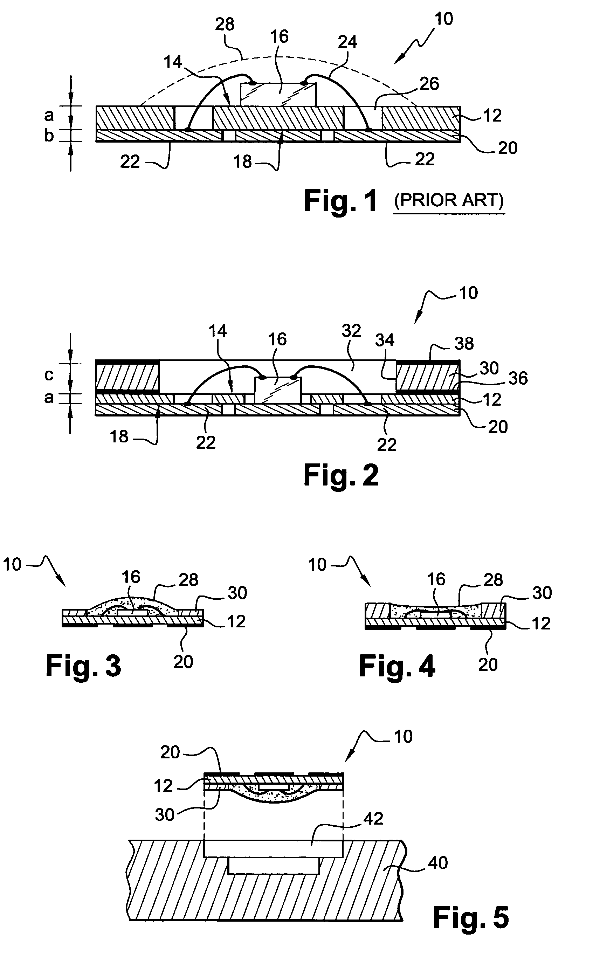

Referring now to the drawings, Figure 1 generally illustrates a chip card module 10 formed on a continuous, flexible band from which modules are individualised by cutting them out before embedding the module into a plastic body for forming the chip card.

The carrier band includes a dielectric, flexible layer 12, generally made out from glass-reinforced epoxy having a thickness a of about 110 µm. This dielectric layer 12 has a backside 14 adapted to support a chip 16 ("backside" being the side of the module which will be hidden once the module is incorporated in the card body, namely after it has been turned upside down with respect to the position of Figure 1).

The opposed side of the dielectric layer 12 is front side 18, which is backed by a conductive layer 20 patterned as a leadframe or metallic grid defining a series of contact pads 22. It is generally made from copper, with a surface-protective metallization on the apparent side and an adhesive applied on the opposed surface at the interface with the dielectric layer 12. Once the chip card is finished, pads 22 will form the contacts enabling exchange of signals with the chip from the outside of the card. Thickness b of the conductive layer 20 is generally about 25 µm.

Contact pads 22 are connected to respective terminals of the chip 16 by means of thin wires 24 via through holes 26 punched out of the dielectric layer 12. Once chip 16 is placed on the backside 14 of the dielectric layer 12, connecting wires 24 are bonded to the inside of the conductive layer 20 in the area of holes 26, then to the corresponding terminals of chip 16 (conventional so-called "wire-bonding" or "die-bonding" techniques).

Then chip 16 and connecting wires 24 are coated with a mass of protective resin 28 applied on the backside 14 of the module. This resin, typically a cross-linkable or curable epoxy resin, protects the chip and the thin wires against environmental damages such as moisture, bending, light, etc. and any mechanical strain that could be applied during further processing.

In order to better control dispensing of this coating resin, the present invention basically proposes to modify the carrier band by including a further layer permitting a precise delimitation of the coating area.

As shown in Figure 2, this additional layer 30 is arranged on the backside 14 of dielectric layer 12. Layer 30 is a layer perforated with the same step as the modules (namely it includes as many perforations as modules supported by the carrier band), each perforation defining an opening around chip 16, so that this chip is surrounded by a peripheral, continuous wall lengthwise and transversely delimitating a clearance area 32 having a given surface and a given thickness. Said given surface corresponds to the surface on which it is required that the resin flows when dispensing it over the chip, whereas said thickness, which is referred to as c, is chosen so as to form a bar against the flow of resin.

In a first embodiment, illustrated in Figure 3, thickness c is chosen rather low, typically 32-40 µm, so that with a somewhat viscous resin the capillarity effect be enough to stop the spreading of the resin, the resin being prevented to overflow the wall formed by the additional layer 30.

In a second embodiment, illustrated in Figure 4, thickness c of the additional layer 30 is chosen relatively high, typically about 300 µm, so that the level of the resin once dispensed be at any rate lower than the top level of the peripheral wall formed by additional layer 30. This enables using resins having any viscosity value, even very fluid resins. This embodiment is accordingly adapted to a wider variety of coating methods.

The additional, perforated layer 30 has a sandwich-like structure comprising a core 34 typically made from plastics such as PET, modified ABS, ABS/PVC or PVC alone, all of them being well known from the man skilled in the art.

The core 34 of the additional layer 30 is coated on its surface in contact with the dielectric layer 12 with a film of double-sided adhesive 36 which enables bonding of layer 30 to layer 12 at the time of manufacturing of the carrier band. Optionally, may be coated on the opposite surface 38, namely on its free surface, with a film of hot-melt adhesive 38 that will be used at the time of the embedding of the module into the card body.

Alternatively, core 34 of the additional layer 30 may be partially or totally comprised of a hot-melt adhesive material.

Addition of layer 30 has the effect of increasing the rigidity of the whole carrier band, so that thickness a of the dielectric layer 12 may be reduced with respect to the typical thickness in prior art carrier bands. For instance, thickness a may be reduced to 30-50 µm or so, the combination of layers 30 and 12 providing to the carrier band a flexibility similar to the one that would have been obtained with a single layer 12 of about 110 µm.

The additional, perforated layer 30 is prepared at the same time as the carrier band, namely it is applied to the dielectric layer 12 and conductive leadframe 20 before placing the chips on the band. In other words, the additional layer is incorporated to the carrier band as produced by the carrier band manufacturer; it remains attached to the carrier band and to the module and is cut with the carrier band as well as the other layers when the individual modules are pressed out from the carrier band.

The manufacturing process according to the invention therefore includes the following steps:
- providing a carrier band 10 including an additional, perforated layer 30 as described above;
- placing chips 16 on the backside of the carrier band at corresponding central chip locations;
- wiring connections 24 between chips 16 and contact pads 22;
- dispensing a quantity of coating resin 28 in the clearance area 32 defined by the opening in the perforated additional layer 30 (it should be noted that the invention provides an improvement to this step with respect to prior art techniques, in so far as the extent of the area on which the resin flows is easily and precisely controlled without requiring application and removal of a mask or the like);
- cross-linking or curing of the resin;
- electrically testing the modules on the band; and
- cutting the band in order to individualise the modules.

The further series of operations concern the embedding of the module in a card body. This is illustrated in Figure 5.

A module 10 has been manufactured as described before, and has to be inserted in a card body 40, typically in a recess 42 milled into this body and the dimensions of which correspond to the ones of the individual module.

The embedding step includes the application of an adhesive on the edge of the module so as to enable peripheral bonding to the card body. If, as described before, the additional 30 already includes a film 38 of hot-melt adhesive, this enables direct embedding of the module into the recess of the card body after cut-out of the module, without requiring an extra step of application of hot-melt adhesive on the periphery of the module.

At any rate, the surface roughness of the apparent face of layer 30 is adapted to the specific adhesive to be used for bonding the module to the card, whether using hot-melt adhesive or liquid cyanoacrylate glue.

## Claims

1. A carrier band for a chip card module (10), said carrier band comprising:
- a dielectric layer (12) with a backside (14) and a front side (18), adapted to support a chip (16) at a chip location on the back side, and
- a conductive layer (20), arranged on the front side of the dielectric layer as a leadframe patterned with contact pads (22) to be connected to respective terminals of the chip,
wherein said carrier band is **characterised by** comprising:
- an additional, perforated layer (30), arranged on the backside (14) of the dielectric layer, said additional layer being perforated so as to define a peripheral wall surrounding a clearance area (32) around the chip location,
whereby said peripheral wall provided by the perforated layer forms a containment barrier against the flow of a coating resin (28) dispensed over the chip in the clearance area.

2. The carrier band of claim 1, wherein the thickness (c) of the perforated layer (30) is chosen as a function of the volume and viscosity of the resin (28) and of the size of the clearance area, so that the level of the resin once dispensed is higher than the level of the peripheral wall, yet the viscosity of the resin prevents the resin from overflowing the peripheral wall (Fig. 3).

3. The carrier band of claim 2, wherein the thickness (c) of the perforated layer (30) is in the range 30-40 µm.

4. The carrier band of claim 1, wherein the thickness (c) of the perforated layer (30) is chosen as a function of the volume of the resin (28) and of the size of the clearance area, so that the level of the resin once dispensed is lower than the level of the peripheral wall (Fig. 4).

5. The carrier band of claim 4, wherein the thickness (c) of the perforated layer (30) is in the range 200-400 µm.

6. The carrier band of claim 1, wherein the dielectric layer (12) is a thin layer with a thickness (a) in the range 30-50 µm.

7. The carrier band of claim 1, wherein the perforated layer (30) includes on its side contacting the dielectric layer an adhesive coating material (36) for adhesion to said dielectric layer.

8. The carrier band of claim 1, wherein the perforated layer (30) includes on its side opposing the dielectric layer a surface coating (38) with a hot-adhesive material.

9. The carrier band of claim 1, wherein the perforated layer (30) is made from a hot-adhesive material.

10. The carrier band of claim 1, wherein the perforated layer (30) comprises a plastic material of the group comprising PET, ABS, PVC, their mixtures and derivatives.

11. A method of manufacturing a chip card, wherein said method is **characterised by** the steps of:
a) providing a carrier band comprising: (i) a dielectric layer (12) with a front side and a back side, (ii) a conductive layer (20) arranged on the front side of the dielectric layer as a leadframe patterned with contact pads (22), and (iii) an additional, perforated layer (30) arranged on the backside of the dielectric layer, said additional layer being perforated so as to define a peripheral wall surrounding a clearance area (32);
b) placing a chip (16) onto the back side of the carrier band at a chip location in the clearance area (32);
c) connecting the contact pads of the conductive layer to respective terminals of the chip;
d) dispensing a coating resin (28) over the chip in the clearance area, the peripheral wall provided by the perforated layer (30) forming a containment barrier against the flow of said resin;
e) hardening the resin;
f) cutting the individual module (10) from the carrier band; and
g) embedding said module (10) in a card body (40) to provide a chip card.

12. The method of claim 11, wherein the perforated layer (30) includes on its side opposing the dielectric layer a surface coating (38) with a hot-adhesive material, and wherein said embedding step g) includes heating the carrier band and adhering the module (10) to the card body (40) by melting the hot-adhesive coating of the peripheral wall.

13. The carrier band of claim 11, wherein the perforated layer (30) is made from a hot-adhesive material, and wherein said embedding step g) includes heating the carrier band and adhering the module (10) to the card body (40) by melting the hot-adhesive peripheral wall.

14. The method of claim 11, wherein said embedding step g) includes applying a liquid adhesive on the upper surface of the peripheral wall of the perforated layer (30) and adhering the module (10) to the card body (40) by pressing said upper surface against the card body.
